# EUROPÄISCHE PATENTSCHRIFT

(11) **EP 1 894 449 B1**
(45) Veröffentlichungstag und Bekanntmachung des Hinweises auf die Patenterteilung: **09.11.2011**
(21) Anmeldenummer: 06754430.4
(22) Anmeldetag: 19.06.2006
(51) Int. Cl.: H05H 1/24, C23C 16/50, C23C 16/54

(54) **VERFAHREN ZUR KONTINUIERLICHEN ATMOSPHÄRENDRUCK PLASMABEHANDLUNG VON WERKSTÜCKEN, INSBESONDERE MATERIALPLATTEN ODER -BAHNEN**
METHOD FOR TREATING PLASMA UNDER CONTINUOUS ATMOSPHERIC PRESSURE OF WORK PIECES, IN PARTICULAR, MATERIAL PLATES OR STRIPS
PROCEDE DE TRAITEMENT PLASMA EN PRESSION ATMOSPHERIQUE CONTINUE DE PIECES D'USINAGE, NOTAMMENT DE MATERIAU EN PLAQUE OU EN BANDE

(30) Priorität: 24.06.2005 DE 102005029360
(43) Veröffentlichungstag der Anmeldung: 05.03.2008
(73) Patentinhaber: Softal Corona & Plasma GmbH, 21107 Hamburg (DE)
(72) Erfinder: PRINZ, Eckhard, 22929 Hamfelde (DE); PALM, Peter, 22549 Hamburg (DE); FÖRSTER, Frank, 22297 Hamburg (DE)
(74) Vertreter: Raffay & Fleck
(86) Internationale Anmeldenummer: PCT/EP2006/005839
(87) Internationale Veröffentlichungsnummer: WO 2007/016999

(56) Entgegenhaltungen:
- EP-A1- 1 448 030
- JP-A- 2002 018 276
- JP-A- 2004 010 994
- JP-A- 2004 068 143
- US-A- 4 723 508

## Beschreibung

Die Erfindung betrifft ein Verfahren zur kontinuierlichen Atmosphärendruck Plasmabehandlung von Werkstücken, insbesondere Materialplatten oder -bahnen, gemäß dem Oberbegriff des Anspruches 1.

In der Veredelungsindustrie oder bei der Herstellung von Kunststofffilmen werden diese durch eine Atmosphärendruck Plasmabehandlung, auch Koronabehandlung genannt, an der Oberfläche aktiviert. Üblicherweise besteht eine industrielle Koronaanlage aus einer Hochspannungselektrode und einer Gegenelektrode, die als Walze ausgeführt ist und über die der eng anliegende Kunststofffilm geführt wird. Die Elektrode ist parallel zur Walze angeordnet, wobei die Elektrode an eine Hochspannung von ca. 10 Kilovolt bei ca. 20-40 Kilohertz angeschlossen und die Walze mit dem Erdpotential verbunden ist. In dem wenige Millimeter betragenden Luftspalt zwischen Hochspannungselektrode und Walze mit Kunststofffilm kommt es durch die Potentialdifferenz zur Ausbildung einer Koronaentladung mit praxisüblichen Leistungen von 1 bis 5 Kilowatt pro Meter. Der Kunststofffilm wird durch die Koronaentladung aktiviert, d.h. an der Oberfläche oxidiert.

Durch die Aktivierung wird die Oberflächenspannung erhöht, um so ausreichende Haftung zu Druckfarben und Klebern zu gewährleisten.

Mit der oben beschriebenen Vorrichtung können dünne Kunststoffilme behandelt werden, aber keine Materialien von mehr als 6 mm Materialdicke, wie zum Beispiel Schäume, Kunststoffplatten, Kunststoffprofile von mehreren Zentimetern Dicke oder auch Holzplatten in ähnlichen Dicken. Der Grund für die Einschränkung ist die mit zunehmendem Elektrodenspalt ungleichmäßige Ausbildung der Entladungskanäle und somit eine ungleichmäßige Aktivierung der Materialoberfläche.

Das Dokument EP1448030 offenbart ein Verfahren zur kontinuierlichen Atmosphärendruck Plasmabehandlung von Werkstücken. Ein zu behandelndes Werkstück ist in einem Abstand unterhalb zwei in Bewegungsrichtung unter Belassung eines Spaltes hintereinander angeordneten, sich quer zu der Bewegungsrichtung über die Breite der zu behandelnden Oberfläche des Werkstückes erstreckenden Barrierenelektroden bestehenden Elektrode angeordnet. An die Barrierenelektroden wird eine Hochspannung in Form einer Wechselspannung angelegt um in dem Spalt eine Plasmaentladung zu zünden, und wobei mittels eines Gasstromes die Plasmaentladung aus dem Spalt in Richtung der zu behandelnden Oberfläche des Werkstückes getrieben wird.

In der DE 102 28 506 A1 ist ein nach einem anderen Prinzip arbeitendes Verfahren zur kontinuierlichen Atmosphärendruckplasmabehandlung von elektrisch isolierenden Werkstücken offenbart, welches Verfahren sämtliche Merkmale des Oberbegriffs des Anspruches 1 enthält. Hier werden also zwei beabstandet voneinander angeordnete Barriereelektroden genutzt, wobei in dem zwischen den Barriereelektroden gebildeten Spalt eine Plasmaentladung gezündet und diese anschließend durch einen Gasstrom in Richtung der zu behandelnden Oberfläche ausgetrieben wird.

Bei dem in dieser Druckschrift offenbarten Verfahren wirkt das Plasma lediglich entlang eines schmalen Streifens, dessen Breite im wesentlichen der Breite des zwischen den Barriereelektroden belassenen Spaltes entspricht, auf die Oberfläche des zu behandelnden Werkstückes ein.

Vor diesem Hintergrund soll mit der Erfindung ein Verfahren angegeben werden, mit welchem ein Werkstück entlang einer größeren Wirkungsbreite kontinuierlich einer Atmosphärendruckplasmabehandlung unterzogen werden kann.

Eine erste Möglichkeit für ein solches Verfahren ist in Anspruch 1 bezeichnet, wobei dieses Verfahren auf dem in der DE 102 28 506 A1 offenbarten Verfahren aufbaut.

Vorteilhafte Weiterbildungen des Verfahrens gemäß Anspruch 1 sind in den abhängigen Ansprüchen 2 bis 5 näher spezifiziert.

Die Elektrode besteht aus mindestens zwei Barrierenelektroden, es können aber auch mehr als zwei Barrierenelektroden unter jeweiliger Belastung eines Spaltes zwischen diesen hintereinander angereiht sein.

Die der zu behandelnden Oberfläche des Werkstückes zugewandten Flächen der Barrierenelektroden werden mit der Hochspannung beaufschlagt. Dadurch zündet aufgrund des oben beschriebenen Effektes über die gesamte Breite der zu behan- ' delnden Oberfläche des Werkstückes eine durch die aufgrund des aus dem Spalt ausgetriebenen Plasmagases in dem Raum zwischen der Elektrode und dem Werkstück vorhandenen Plasmaspezies herabgesetzte Zündspannung ermöglichte Plasmaentladung, die eine Behandlung der Oberfläche des Werkstückes über dessen gesamte Breite ermöglicht. Dieses Phänomen wird hier als "kapazitiv koppelnde Entladung" bezeichnet.

Nach einer einfachen Variante ist die Elektrode aus zwei Einkanal-Barrierenelektroden aufgebaut. Erfindungsgemäß kommt es bei einer Annäherung des Werkstückes an die Elektrode auf einen angepassten Abstand und bei geeigneter Wahl der weiteren Parameter (Hochspannung, Atmosphäre) durch die dielektrische Masse des Werkstückes zu einer kapazitiven Kopplung. Durch die Anwesenheit der in dem Spalt zwischen den Barrierenelektroden gebildeten und in Richtung der Werkstückoberfläche aus dem Spalt ausgetriebenen Plasmaspezies kommt es somit zur Ausbildung einer gleichmäßigen Entladung zwischen den Barrierenelektroden und dem Werkstück, ähnlich einer Glimmentladung im Vakuumplasma. Die Elektrode wird vornehmlich mit Luft als Prozessgas betrieben, kann aber auch in Fremdgasatmosphären wie z.B. in Stickstoff oder Gemischen aus Stickstoff mit anderen Gasen wie Sauerstoff, Kohlendioxid, Wasserstoff oder Edelgasen betrieben werden. Durch die Entladung wird die Werkstückoberfläche je nach Gasart oxidiert, bzw. es werden andere chemische Gruppen wie z.B. Amine, Amide oder Imide eingebaut. Dadurch wird die Oberflächenenergie des Werkstückes gesteigert und somit die Haftung zu Farben, Lacken, Klebern oder anderen Beschichtungen ermöglicht bzw. verbessert. Ein Vorteil des erfindungsgemäßen Verfahrens liegt insbesondere darin, dass sich durch die kapazitive Kopplung die Entladung den Abmessungen der Werkstückes anpasst, d.h. die Entladung zündet vornehmlich auf der Werkstückoberfläche und nicht daneben. Dies führt zu einer ortsgenauen Entladung und mithin auch zu einer Einsparung der für die Zündung und Aufrechterhaltung der Entladung erforderlichen Energie.

Der Spalt zwischen den Barrierenelektroden ist bevorzugt von 0,5 Millimeter bis 5 Millimeter breit. Spalte dieser Breiten eignen sich bei den für die Durchführung des Verfahrens bevorzugten Spannungsbereichen besonders gut für die Zündung des gewünschten Plasmas.

Die Barrierenelektroden sind bevorzugt aus Aluminiumoxidkeramik gebildet. Dieses Material ist besonders beständig.

Bevorzugt sind die Barrierenelektroden aus Rechteckrohren mit je einem oder mehreren Kanälen gebildet.

Die Barrierenelektroden sind bevorzugt an einem Haltekörper angeordnet. Jedoch können die Barrierenelektroden auch mittels Elektrodenträger über Isolatoren an einer Halteplatte fixiert sein. Durch eine Abdichtung des Bauraumes zwischen den Barrierenelektroden und der Halteplatte wird in diesem Fall eine Kammer gebildet, in die Luft oder ein anderes Gas eingespeist werden kann, um dann durch den sich dadurch aufbauenden Überdruck durch den Spalt zu strömen und die Entladung aus dem Spalt in Richtung des Werkstückes zu treiben.

Mit einer Verfahrensführung gemäß Anspruch 2 kann eine zusätzlich Beschichtung der Werkstückoberfläche mit aus den Precursoren im Plasma gebildeten chemischen Verbindungen erreicht werden.

Gemäß einer Weiterbildung der Erfindung wird wie in Anspruch 3 beschrieben eine Gegenelektrode angeordnet. Diese kann bevorzugt in Form einer als Elektrode ausgebildeten Auflagefläche gebildet sein. Im Falle von dicken isolierenden Materialien, wie beispielsweise Platten, Profilen, Hohlkammerprofilen, Stegplatten und dgl., kann die Gegenelektrode entfallen. Materialen mit geringer dielektrischer Masse wie Kunststofffilme, Schäume, Luftpolsterfilm, Papiere, Kunststofffasern oder Naturfasern, Granulate oder Pulver sind mit einer Gegenelektrode zu behandeln. Die Gegenelektrode kann dabei als dielektrische Masse (Walze, Transportband) bzw. als geerdete Metallwalze oder Platte mit Dielektrikum (Silikon oder Keramik) oder ohne Dielektrikum ausgeführt sein. Im Falle einer dielektrischen Walze wird mit der kapazitiv koppelnden Entladung bei der Behandlung von Kunststofffilmen bei Dellen in der Walze die Rückseitenbehandlung vermieden bzw. stark unterdrückt. Eine Gegenelektrode kann auch eine spiegelbildlich zu der die Entladung bewirkende Elektrode aufgebaute Elektrode sein. Das Werkstück wird dann zwischen beiden Elektroden hindurchgeführt. Somit ist auch eine doppelseitige Behandlung des Substrats möglich.

Für die Erzeugung einer für die Zündung der Plasmaentladung erforderlichen Hochspannung wird vorzugsweise ein symmetrischer Transformator mit einer mit einem Generator verbundenen Primärspule und zwei je mit einer der Barrierenelektroden verbundenen Sekundärspulen verwendet (Anspruch 4). Statt eines Betriebes mit einem gemeinsamen Transformator ist auch ein Betrieb mit zwei getrennten Transformatoren möglich. Diese können im Takt bzw. Gegentakt betrieben werden.

Im Falle von elektrisch leitfähigen Materialien, wie metallisierten Kunststofffilmen, ist die Hochspannung durch einen symmetrischen Transformator halbiert. Dadurch wird die dünne Metallschicht nicht durch die Plasmaentladung beschädigt.

Um bei der Plasmaentladung entstehendes Ozon und andere Beiprodukte sicher von der Bearbeitungsstelle ableiten zu können, ist die Elektrode vorzugsweise in einem tunnelartig auf der der Werkstückoberseite zugewandten Seite offenen Gehäuse angeordnet, und das Gehäuse ist an eine Absaugung angeschlossen (vgl. Anspruch 5).

Ein alternatives Verfahren, welches die gleiche, oben angegebene Aufgabe löst, greift nicht auf eine Weiterbildung des Standes der Technik gemäß der DE 102 28 506 A1 zurück, sondern verwendet einen alternativen Ansatz.

Die wesentlichen Merkmale des Verfahrens hier besteht darin, die Zündung eines Plasmas in einem bestimmten Bereich durch die Art der Atmosphäre in diesem Bereich und eine entsprechende Einstellung einer passenden Hochspannung zu steuern. Bei dieser Variante soll ein Plasma nur auf der der Elektrode gegenüberliegenden Seite einer Materialbahn oder - Platte gezündet werden. Hierzu wird in dem Bereich zwischen der Elektrode und der ersten Seite des Werkstückes eine erste Atmosphäre eingestellt, in welcher bei einer gewählten Hochspannung ein Plasma noch nicht zündet. Auf der gegenüberliegenden Seite Materialbahn wird eine von der ersten Atmosphäre abweichende, zweite Atmosphäre eingestellt, in welcher induziert durch die an der Elektrode anliegende Hochspannung eine Plasmazündung bereits erfolgen kann. So wird gezielt nur auf der "Rückseite" der Materialbahn bzw. - Platte ein Plasma gezündet, so dass dort eine großflächige Plasmabehandlung stattfindet. Auch hierbei handelt es sich um eine "kapazitiv koppelnde Entladung" im Sinne der Erfindung, wobei die Entladung sich auch in diesem Beispiel über die gesamte Breite und Länge der Elektrode ereignet, allerdings beschränkt ist auf die Abmessungen des jeweils zu behandelnden Materials.

Weitere Vorteile und Merkmale der Erfindung ergeben sich aus der nachfolgenden Beschreibung der Erfindung anhand von in den Figuren dargestellten Ausführungsbeispielen. In den Figuren zeigen:
- Fig. 1: eine in einer Förderrichtung eines kontinuierlich zu beschichtenden Werkstücks genommene, schematische Schnittansicht einer Vorrichtung zur Durchführung des erfindungsgemäßen Verfahrens in der ersten Variante;
- Fig. 2: eine Prinzipskizze der elektrischen Verschaltung der Elektrode der in Fig. 1 gezeigten Vorrichtung;
- Fig. 3: eine in Bewegungsrichtung des zu beschichtenden Werkstückes genommene, schematische Ansicht eines Ausschnittes der Vorrichtung mit gezündetem Plasma;
- Fig. 4a und 4b: zwei mögliche Verschaltungsvarianten einer alternativen Ausgestaltung einer Elektrode mit zwei Doppelkanal-Barrierenelektroden;
- Fig. 5: eine weitere mögliche Verschaltung von zwei Doppelkanal-Barrierenelektroden, wobei in diesem Fall zusätzlich ein Precursor in die gezündete Plasmaentladung gegeben wird; und
- Fig. 6: eine schematische Darstellung eines Verfahrens gemäß der zweiten Variante.

In den Figuren sind gleiche bzw. gleichartige Elemente mit gleichen Bezugsziffern versehen.

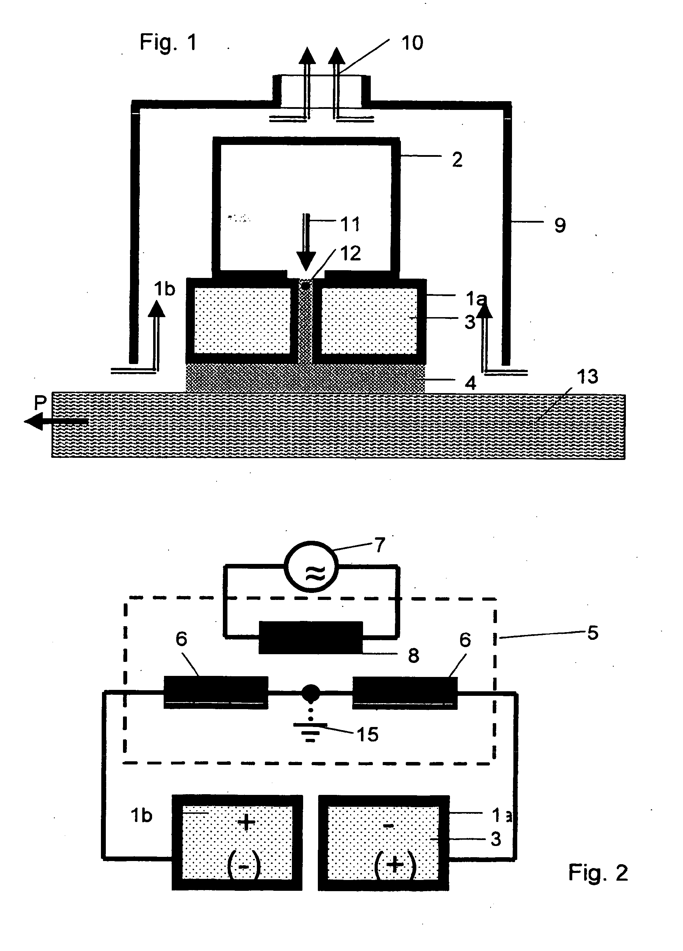

In Fig. 1 ist zunächst schematisch ein entlang einer Ebene, in welcher die Bewegungsrichtung liegt, genommener Querschnitt durch eine Vorrichtung zur Durchführung eines erfindungsgemäßen Verfahrens gemäß der ersten Alternative gezeigt. Die erfindungsgemäße Vorrichtung weist eine aus zwei in Bewegungsrichtung (Pfeil P) eines Werkstückes 13 hintereinander angeordnete Barrierenelektroden 1a, 1b auf. Zwischen den Barrierenelektroden 1a, 1b ist ein Spalt 12 belassen. Die Barrierenelektroden 1a, 1b sind an einem Haltekörper 2 angeordnet, der zugleich eine Kammer zum Einbringen eines Gases 11, vorzugsweise Luft oder Stickstoff bzw. eines stickstoffhaltigen Gasgemisches, bildet, um dieses Gas bzw. Gasgemisch durch den Spalt 12 in Richtung auf die zu behandelnde Oberfläche des Werkstückes 13 zu treiben. Ein in dem Spalt 12 zwischen den Barrierenelektroden 1a, 1b gezündetes Plasma wird durch das ständig in den Spalt nachgeführte Gas bzw. Gasgemisch in den Bereich zwischen den Barrierenelektroden 1a, 1b sowie dem Werkstück 13 transportiert und strömt schließlich nach beiden Seiten in und gegen die Bewegungsrichtung (Pfeil P) aus diesem Bereich ab. Ober der Anordnung aus Haltekörper 2 und Elektrode (Barrierenelektroden 1a, 1b) ist ein in Richtung des Werkstückes 13 offenes, tunnelförmiges Gehäuse 9 angeordnet, welches über eine obere Öffnung an eine hier schematisch dargestellte Absaugung 10 angeschlossen ist. Das Werkstück 13 wird über hier nicht dargestellte Mechanismen in der Bewegungsrichtung (Pfeil P) transportiert. Hierzu kann es bspw. auf einer Auflagefläche (z.B. einem Transportband) aufliegen, kann aber auch eigensteif und ohne Auflagefläche unter der Elektrode hinweg transportiert werden. In den Barriereelektroden 1a, 1b, die im vorliegenden Fall Rechteckrohre aus Aluminiumoxidkeramik sind, verläuft ein hier schematisch angeordneter elektrischer Leiter 3, um eine entsprechende Spannung auf die jeweilige Barrierenelektrode 1a, 1b aufbringen zu können. Die Barrierenelektroden 1a, 1b weisen in diesem Ausführungsbeispiel eine Länge von bis zu mehreren Metern auf. Als elektrischer Leiter 3 kommt beispielsweise eine Metallpulverfüllung oder aber auch eine Metallbeschichtung der Elektrode von Innen in Betracht.

In Fig. 2 ist schematisch eine elektrische Verschaltung der Barrierenelektroden 1a, 1b dargestellt. Zur Versorgung der Barrierenelektroden 1a , 1b mit einer Hochspannung weist die Vorrichtung einen hier mit einer mit 5 bezeichneten Umrandung angedeuteten Transformator auf, welcher hier ein symmetrischer Transformator mit einer Primärspule 8 und zwei Sekundärspulen 6 ist. Die Sekundärspulen 6 sind jeweils mit einer der Barrierenelektroden 1a, 1b und mit Masse 15 verbunden. Die Verbindung zur elektrischen Masse 15 kann auch entfallen. An die Primärspule 8 des Transformators 5 ist ein Wechselspannungsgenerator 7 angeschlossen. Die Spannung kann dabei im Takt bzw. im Gegentakt geschaltet sein.

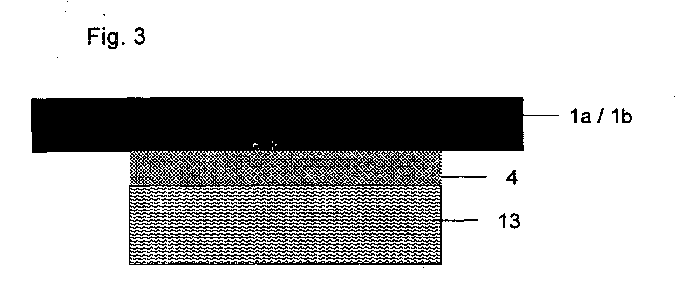

In diesem Beispiel wird eine Sinusspannung zwischen 10 bis 60 Kilovolt mit einer Frequenz von 1 bis 100 Kilohertz, vorzugsweise 5 bis 30 Kilohertz verwendet. Die Spannung kann dabei auch gepulst sein. Durch den symmetrischen Transformator wird die Spannung gleichmäßig auf beide Barrierenelektroden 1a, 1b aufgebracht, so dass in dem Spalt 12 ein Plasma gezündet werden kann. Der Spalt 12 hat eine Spaltbreite von 0,5 bis 5 Millimeter, vorzugsweise 1 Millimeter. Durch den Strom des Gases 11 in den Spalt 12 bzw. durch diesen hindurch in Richtung der Oberfläche des Werkstückes 13 wird das gezündete Plasma 4 in Richtung der zu behandelnden Oberfläche des Werkstückes 13 transportiert. Im Plasmagas ist die Zündspannung herabgesetzt. Deshalb kommt es bei einer Annäherung des Werkstückes 13 auf einen Abstand zu den Elektroden von 1 Millimeter bis 20 Millimeter durch die dielektrische Masse des Werkstückes 13 zu einer kapazitiven Kopplung und somit zur Ausbildung einer gleichmäßigen Entladung 4 zwischen der zu behandelnden Oberfläche des Werkstückes 13 und den zugewandten Oberflächen der Barrierenelektroden 1a, 1b. Diese Entladung 4 ist ähnlich einer Glimmentladung im Vakuumplasma. Durch die kapazitive Kopplung passt sich die Entladung 4 in ihren Dimensionen den Abmessungen des Werkstückes an, d.h. die Entladung 4 zündet vornehmlich auf der Werkstückoberfläche und nicht daneben. Dies ist schematisch in Fig. 3 dargestellt, welche eine in der Bewegungsrichtung (Pfeil P) gesehene schematische Ansicht auf eine der Barrierenelektroden 1a und das darunter weggeführte Werkstück 13 ist.

Im Betrieb der Vorrichtung hat das Werkstück 13 unterhalb der aus den beiden Barrierenelektroden 1a, 1b gebildeten Elektrode hinweggefördert, so dass eine kontinuierliche Plasmabehandlung der der Elektrode zugewandten Oberfläche des Werkstückes 13 entlang seiner gesamten Breite erreicht wird.

Durch das über den Haltekörper 2 zugeführte Gas 11 (beispielsweise Luft) wird nicht nur die Entladung aus dem Spalt 12 in Richtung der zu behandelnden Oberfläche des Werkstückes 13 ausgelenkt, sondern es werden gleichzeitig auch die Barrierenelektroden 1a, 1b gekühlt.

Auch die thermische Beanspruchung des behandelten Werkstückes ist gering. Nach einer Behandlung mit der in Fig. 1 dargestellten Vorrichtung wird eine Temperaturerhöhung von lediglich ca. 5°C festgestellt.

Neben einer elektrischen Verschaltung für eine sogenannte kapazitiv koppelnde Entladung, wie sie in Fig. 2 angegeben ist, bei der die Entladung auf der dem Werkstück zugewandten Seite ausgelenkt wird und zwischen der gesamten der zu behandelnden Oberfläche des Werkstückes 13 zugewandten Oberfläche der Elektrode und der zu behandelnden Oberfläche des Werkstückes 13 stattfindet, kommen weitere mögliche Betriebsmodus einer. Vorrichtung in Betracht.

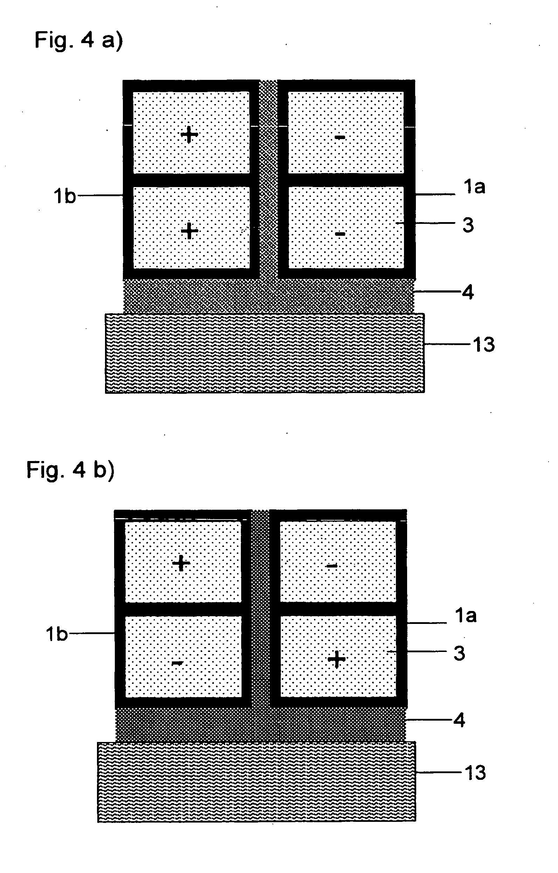

So können mit einer abgewandelten Vorrichtung, welche anstelle zweier einfacher Rechteckrohre als Barrierenelektroden 1a, 1b jeweils ein Doppelkanalrohr enthält, kapazitiv koppelnde Entladungen erzielt werden (siehe Fign. 4a und 4b).

In diesen Fällen sind die Barrierenelektroden 1 durch zwei Doppelkanalrohre realisiert, welche beide mit Leitern 3 ausgestattet sind. An den symmetrischen Transformator sind die Barrierenelektroden entweder parallel angeschlossen wie in Fig. 4a gezeigt, oder aber auch antiparallel (Fig. 4b). Beim antiparallelen Anschluss kommt es durch die höhere Feldliniendichte des elektrischen Feldes im Spalt zwischen den Barrierenelektroden 1a, 1b zu einer höheren Energieeinkopplung. Durch die Vorionisation der Ladungsträger im Spalt 12 kann die Fernwirkung der die Elektrode verlassenden Ladungsträger in Richtung Werkstück 13 im Vergleich zur Anordnung mit zwei Einkanal-Barrierenelektroden (Fig. 1) erweitert werden. Somit kommt es zur Ausbildung eines linearen Plasmafreistrahls, insbesondere bei großem Abstand zum Werkstück, welche von der Größe der dielektrischen Masse abhängt. Bei einer Annäherung des Werkstücks 13 an die Elektrode zieht sich die Entladung 4 erfindungsgemäß durch kapazitive Kopplung zum Werkstück 13 hin.

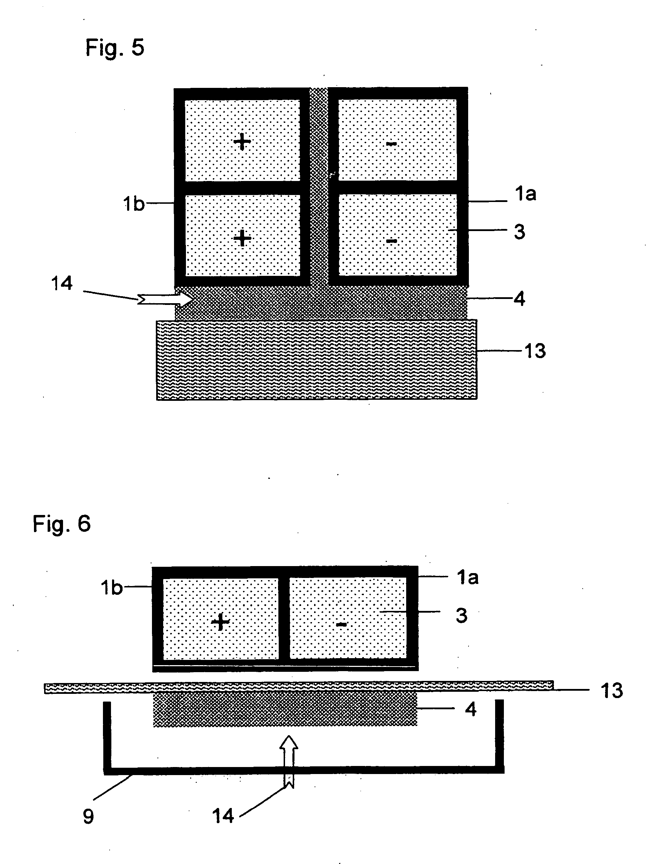

Eine weitere Variante ist in Figur 5 dargestellt. Hier werden sogenannte Precursoren 14 in die Plasmaentladung zur Abscheidung von Schichten auf dem Werkstück 13 eingespeist. Derartige Precursoren 14 können z.B. Tetramethylorthosilikat, Hexamethylendisiloxan in Form von Dampf oder Aerosolen sein. Mit den genannten Precursoren 14 kann z.B. eine Siliziumdioxidschicht im Bereich von wenigen Nanometern bis Mikrometern auf der Oberfläche des Werkstückes abgeschieden werden. Bei der kapazitiv koppelnden Entladung wird ein Precursorenstrom wie gezeigt vorzugsweise in die kapazitiv gekoppelte Entladungszone zwischen die der Oberfläche des zu behandelnden Werkstoffes 13 zugewandten Oberflächen der Barrierenelektrode 1a, 1b und die zu behandelnde Oberfläche des Werkstückes 13 eingespeist.

Wichtig ist, dass die Precursoren 14 nicht zwischen die an die Hochspannung angeschlossenen Elektroden eingespeist werden, um zu verhindern, dass letztere beschichtet werden.

In Fig. 6 schließlich ist schematisch die Durchführung eines Verfahrens gemäß der Alternative dargestellt.

Hier ist gezeigt, wie eine Elektrode, die sich in diesem Fall aus einer Doppelkanalbarrierenelektrode 1a, 1b zusammensetzt auf der einen Seite eines Werkstückes 13 (einer Materialbahn oder -Platte) angeordnet ist und auf der gegenüberliegenden Seite des Werkstückes 13 gegenüber der Elektrode 1a, 1b ein Gehäuse 9 angeordnet ist. In das Gehäuse 9 wird eine solche Atmosphäre eingespeist, die bei einer an die Elektrode 1a, 1b angelegten Wechsel-Hochspannung die Zündung einer Plasmaentladung 4 auf dieser Seite des Werkstückes 13 ermöglicht, wobei in dem Bereich zwischen der Elektrode 1a, 1b und im Werkstück 13 eine entsprechend andere Atmosphäre herrscht, die eine Plasmaentladung noch unterdrückt. Auf diese Weise wird das Werkstück 13 von einer der Elektrode 1a, 1b gegenüberliegenden "Rückseite" her großflächig beschichtet. Die Atmosphäre in dem Gehäuse 9 wird auch bei diesem Verfahren abgesaugt, um unerwünschte Plasmaprodukte, wie insbesondere Ozon, nicht in die Umgebung gelangen zu lassen. In dieser Figur ist dargestellt, wie zusätzlich Precursoren 14 in den Bereich der Plasmaentladung 4 eingebracht werden. Dies ist möglich, jedoch nicht erforderlich. Das Verfahren funktioniert ebenso gut ohne das Einbringen von Precursoren.

Die Elektrode 1a, 1b kann beispielsweise auch durch eine aus zwei durch einen Spalt voneinander getrennten einzelnen Barrierenelektroden gebildete Elektrode sein (ein Elektrodenpaar). Solange der Spalt nicht zu groß wird, wird sich auf der dem Gehäuse 9 zugewandten Seite des Werkstückes 13 noch immer eine durchgehende Plasmaentladung ausbilden, die auf dieser Seite des Werkstückes eine erwünschte Oberflächenveränderung hervorruft.

Weitere mögliche Anwendungsfälle sind z.B. denkbar für die Innenbehandlung bzw. Innenbeschichtung von planaren dreidimensionalen Bauteilen. Hierbei werden elektrisch isolierende Werkstücke mit Kanälen im Inneren behandelt bzw. beschichtet. Dazu werden die Kanäle mit einem Edelgas, z.B. Argon durchströmt, wodurch gemäß dem Paschengesetz die Zündspannung abgesenkt wird, damit die Entladung im Inneren zündet. Wie bereits oben beschrieben, zündet die kapazitiv koppelnde Entladung vornehmlich auf dem Werkstück und nicht in dem sich daneben aufspannenden Gasraum und somit vornehmlich in den Kanälen des Werkstückes. Wird der Trägergasstrom mit dem Dampf bzw. Aerosol eines Precursors versehen, werden in den Kanälen Schichten abgeschieden. Bei der Behandlung liegt das Werkstück auf einer Gegenelektrode auf. Statt des reinen Edelgases können auch Gemische mit Luft, Stickstoff, Sauerstoff und dgl. eingesetzt werden.

Ferner kann eine kapazitive Kopplung in einer großvolumigen Reaktionskammer durchgeführt werden. In einer großvolumigen Kammer, die von einem Edelgas durchströmt wird, wird durch Aufsetzen der Barrierenelektroden durch die oben beschriebene kapazitive Kopplung die Plasmaentladung in der gesamten Kammer gezündet. Je nach Größe der Kammer sind mehrere Elektroden erforderlich. Statt des reinen Edelgases können auch hier wieder Gemische mit Luft und Stickstoff, Sauerstoff und dgl. eingesetzt werden. Auch hier können im Falle von erwünschten Beschichtungen dem Trägergas Precursoren beigemischt werden.

Bei der Umsetzung ist es auch denkbar, Schmelzen an einem Extruder zu behandeln. Mit der kapazitiv koppelnden Entladung lassen sich auch Polymerschmelzen kurz nach dem Austritt aus einer Extruderdüse behandeln, um dadurch die Haftung zu einer zu beschichtenden Bahn zu gewährleisten.

Ebenfalls ist es möglich, mit der Vorrichtung bzw. mit dem erfindungsgemäßen Verfahren sowohl im Modus der kapazitiv koppelnden Plasmaentladung Flüssigkeiten zu aktivieren. Dabei können an der Grenzfläche Plasma-Flüssigkeit chemische Reaktionen induziert werden, deren Produkte dann in die Flüssigkeit hinein diffundieren können. Auch ist es möglich, mittels einer erfindungsgemäßen Plasmaentladung dünne Flüssigkeitsfilme zu vernetzen.

### Beschreibung von Behandlungsbeispielen:

### 1. Rückseitenfreie Behandlung durch kapazitiv koppelnde Entladung

Ein LDPE Film mit Oberflächenenergie (vor der Plasmabehandlung) von 30 mN/m jeweils auf beiden Seiten wurde auf der den Barrierenelektroden zugewandten Seite mit Plasma behandelt. Der LDPE Film war frei gespannt, d.h. es wurde keine Gegenelektrode verwendet. Die Plasmabehandlung erfolgte mit einer aus einem im Abstand von 0,5 mm unter Belassung eines Spaltes parallel zueinander angeordneten Paar Doppelkanalrohre gebildeten Elektrode gemäß Abb. 4a. Der Film wurde mit einem Lineartisch mit einer Geschwindigkeit von 60 m/min unter der Elektrode hinwegbewegt. Dabei betrug der Abstand der Barrierenelektroden zum LDPE Film 1,5 mm.

An die Doppelbarrierenelektrode wurde eine elektrische Energie von 500 Watt bei Frequenz der Wechselhochspannung von 8 Kilohertz angelegt. In den Spalt zwischen den beiden Doppelkanalrohren der Doppelbarrierenelektroden wurde bei im wesentlichen Atmosphärendruck Blasluft eingespeist. Unter den o.g. Randbedingungen zündete das Plasma zwischen den Barrierenelektroden und wurde durch die Blasluft auf den LDPE Film ausgetrieben. Durch die in den Zwischenraum zwischen der Doppelbarrierenelektrode und dem LDPE Film ausgeblasenen Plasmaspezies wurde die Zündspannung in diesem Bereich soweit herabgesetzt, dass eine "Sekundärzündung" eines großflächigen Plasmas im gesamten Bereich zwischen den der Oberfläche des LDPE Film und der dem Film zugewandten Oberflächen der Barrierenelektroden (Remote-Entladung) gezündet wurde. Es wurden zehn Behandlungen vorgenommen.

Die Oberflächenenergie wurde mit Testtinten gemäß DIN ISO 8296 gemessen.

Aufgrund der oben geschilderten Plasmabehandlung konnte eine Steigerung der Oberflächenenergie durch kapazitiv koppelnde Entladung auf der Barrierenelektrodenseite des LDPE Films auf 42 mN/m erreicht werden, was ein typischer Wert für die Druckvorbehandlung ist. Die Oberflächenenergie auf der den Barrierenelektroden abgewandten Seite des LDPE Films (Filmrückseite) betrug weiterhin 30 mN/m. Es hat hier also keine Behandlung stattgefunden.

### 2. Behandlung von Stegplatten

Eine 7,5 mm dicke Polypropylenstegplatte mit Oberflächenenergie (vor der Plasmabehandlung) von 30 mN/m jeweils auf beiden Seiten, wurde auf der den Barrierenelektroden zugewandten Seite mit Plasma behandelt. Dazu war die Polypropylenstegplatte frei gespannt, d.h. es war keine Gegenelektrode vorhanden.

Die Plasmabehandlung erfolgte mit einem unter Belassung eines Spaltes im Abstand von 0,5 mm parallel zueinander angeordneten Paar Doppelkanalrohre gemäß Abb. 4a.

Die Stegplatte wurde mit einer Geschwindigkeit von 10 m/min mit einem Lineartisch unter dem Elektrodensystem hinwegbewegt.

Die an die Doppelbarrierenelektrode angelegte elektrische Energie betrug 500 Watt bei einer Frequenz der Wechselhochspannung von 8 Kilohertz. Der Abstand der Barrierenelektroden zur Stegplatte betrug 1,0 mm. In den Spalt zwischen den beiden Doppelkanalrohren der Doppelbarrierenelektroden wurde Blasluft eingespeist.

Unter den o.g. Randbedingungen zündete das Plasma zwischen den Barrierenelektroden und wurde durch die Blasluft auf die Stegplatte ausgetrieben. Durch die in den Zwischenraum zwischen der Doppelbarrierenelektrode und der Stegplatte ausgeblasenen Plasmaspezies wurde die Zündspannung in diesem Bereich soweit herabgesetzt, dass eine "Sekundärzündung" eines großflächigen Plasmas im gesamten Bereich zwischen den der Oberfläche der Stegplatte und der der Platte zugewandten Oberflächen der Barrierenelektroden (Remote-Entladung) gezündet wurde. Es wurden zwei Behandlungen vorgenommen.

Die Oberflächenenergie wird mit Testtinten gemäß DIN ISO 8296 gemessen.

Durch diese Plasmabehandlung erfolgte eine Steigerung der Oberflächenenergie aufgrund der kapazitiv koppelnden Entladung auf der Barrierenelektrodenseite von der Polypropylen Stegplatte auf 50 mN/m, was ein typischer Wert für die Verklebbarkeit ist. Die Rückseite der Stegplatte erfuhr keine Behandlung, der Wert der Oberflächenenergie blieb bei den ursprünglichen 30 mN/m.

### Bezgugszeichenliste

- 1a,b: Barrierenelektrode
- 2: Haltekörper
- 3: elektrischer Leiter
- 4: Plasmaentladung
- 5: Transformator
- 6: Sekundärspule
- 7: Generator
- 8: Primärspule
- 9: Gehäuse
- 10: Absaugung
- 11: Gas
- 12: Spalt
- 13: Werkstück
- 14: Precursor
- 15: elektrische Masse

- P: Pfeil

## Patentansprüche

1. Verfahren zur kontinuierlichen Atmosphärendruck Plasmabehandlung von insbesondere elektrisch isolierenden Werkstücken, insbesondere Materialplatten oder -bahnen, wobei ein zu behandelndes Werkstück in einem Abstand unterhalb einer aus wenigstens zwei in Bewegungsrichtung unter Belassung eines Spaltes hintereinander angeordneten, sich quer zu der Bewegungsrichtung zumindest über die Breite der zu behandelnden Oberfläche des Werkstückes erstreckenden Barrierenelektroden bestehenden Elektrode angeordnet und die Elektrode und das Werkstück in einer Bewegungsrichtung relativ zueinander in Bewegung versetzt werden, wobei an die Barrierenelektroden eine Hochspannung in Form einer Wechselspannung angelegt wird, um zumindest in dem Spalt eine Plasmaentladung zu zünden und wobei mittels eines Gasstromes die Plasmaentladung aus dem Spalt in Richtung der zu behandelnden Oberfläche des Werkstückes getrieben wird, **dadurch gekennzeichnet, dass** der zu behandelnden Oberfläche des Werkstückes zugewandte Flächen der Barrierenelektroden mit der Hochspannung beaufschlagt werden, wodurch eine aufgrund des aus dem Spalt austretenden, in den Bereich zwischen den Barrierenelektroden und der zu behandelnden Oberfläche des Werkstückes strömenden Plasmagases verminderte Zündspannung für eine Zündung einer zwischen den dem Werkstück zugewandten Oberflächen der Barrierenelektroden und der zu behandelnden Oberfläche des Werkstückes erreicht und damit ein über die gesamte Breite des Werkstückes wirkendes Plasma gezündet wird.

2. Verfahren nach Anspruch 1, **dadurch gekennzeichnet, dass** in dem Bereich zwischen den Barriereelektroden und der zu behandelnden Oberfläche des Werkstückes chemische Reagenzien (Precursoren) in das Plasma eingebracht werden.

3. Verfahren nach einem der Ansprüche 1 oder 2, **dadurch gekennzeichnet, dass** auf der der Elektrode gegenüberliegenden Seite des Werkstückes eine Gegenelektrode angeordnet wird.

4. Verfahren nach einem der Ansprüche 1 bis 3, **dadurch gekennzeichnet, dass** die Hochspannung mit einem symmetrischen Transformator mit einer mit einem Generator verbundenen Primärspule und zwei je mit einer der Barrierenelektroden verbundenen Sekundärspulen erzeugt wird.

5. Verfahren nach einem der Ansprüche 1 bis 4, **dadurch gekennzeichnet, dass** im Bereich der Plasmabehandlung entstehende Gase abgesaugt werden.

## Claims

1. A method of continuous plasma treatment under atmospheric pressure of in particular electrically insulating parts, in particular material plates or strips, wherein a workpiece to be treated is arranged at a distance beneath one electrode composed of at least two barrier electrodes, arranged behind one another and leaving a gap in moving direction, extending crosswise to the moving direction at least across the width of the surface of the workpiece to be treated and whereas the electrode and the work piece are offset and moved relative to one another in a moving direction,
wherein high voltage in the form of an alternate voltage is applied to the barrier electrodes, in order to ignite a plasma discharge at least in the gap and wherein the plasma discharge is driven by means of a gas flow from the gap in the direction of the surface of the workpiece to be treated, **characterised in that** faces of the barrier electrodes facing the surface of the part to be treated are acted upon by the high voltage, which enables to reach an ignition voltage which is reduced due to the plasma gas coming out the gap and flowing into the region between the barrier electrodes and the surface of the workpiece to be treated and which is intended for igniting a surface between the surfaces of the barrier electrodes pointing to the workpiece and the surface of the workpiece to be treated with the consequence that a plasma acting over the whole width of the workpiece is ignited.

2. The method of claim 1, **characterised in that** chemical reactants (precursors) are introduced into the plasma in the area between the barrier electrodes and of the surface of the workpiece to be treated.

3. The method according to any of the claims 1 or 2, **characterised in that** a counter electrode is arranged on the side of the workpiece opposite to the electrode

4. The method according to one of the claims 1 to 3, **characterised in that** the high voltage is generated by means of a symmetrical transformer fitted with a primary coil connected to a generator and two secondary coils each connected to one of the barrier electrodes.

5. The method according to one of the claims 1 to 4, **characterised in that** gases generated in the region of the plasma treatment are expelled.

## Revendications

1. Procédé de traitement plasma à la pression atmosphérique continue pour pièces électriquement isolantes en particulier, en particulier des plaques ou des bandes de matériau, dans lequel une pièce à traiter est située à une distance donnée sous une électrode composée d'au moins deux électrodes barrières disposées les unes derrière les autres en laissant un espace dans le sens de mouvement et disposée perpendiculairement au sens de déplacement au moins sur la largeur de la surface à traiter de la pièce d'usinage, et l'électrode et la pièce d'usinage sont décalées l'une par rapport à l'autre dans un sens de mouvement,
dans lequel une haute tension sous forme de tension alternative est apliquée aux électrodes barrières, pour au moins allumer une décharge plasma dans l'espace et tandis que la décharge plasma est entraînée de l'espace dans le sens de la surface à traiter de la pièce d'usinage par le biais d'un courant de gaz, **caractérisé en ce que** des faces des électrodes barrières dirigées vers la surface à traiter de la pièce d'usinage sont excitées par une haute tension, permettant d'obtenir une tension d'allumage réduite par le gas plasma sortant de l'espace et s'écoulant dans la zone entre les électrodes barrières et la surface à traiter de la pièce d'usinage, tension prévue pour une surface entre les surfaces des électrodes barrières dirigées vers à la pièce d'usinage et la surface à traiter de la pièce d'usinage, avec pour résultat d'allumer un plasma agissant sur toute la largeur de la pièce d'usinage.

2. Procédé selon la revendication 1, **caractérisé en ce que** l'on introduit des réactifs chimiques (précurseurs) dans le plasma dans la zone comprise entre les électrodes barrières et la surface à traiter de la pièce d'usinage.

3. Procédé selon l'une des revendications 1 ou 2, **caractérisé en ce qu'**une contre-électrode est disposée sur le côté de la pièce d'usinage opposé à l'électrode.

4. Procédé selon l'une quelconque des revendications 1 à 3, **caractérisé en ce que** la haute tension est générée par un transformateur de manière symétrique disposant d'une bobine primaire connectée à un générateur et deux bobines secondaires connectées chacune à l'une des électrodes barrières.

5. Procédé selon l'une quelconque des revendications 1 à 4, **caractérisé en ce que** les gaz produits dans la zone de traitement plasma sont évacués.
